# FASCICULE DE BREVET EUROPEEN

(11) **EP 2 834 857 B1**
(45) Date de publication et mention de la délivrance du brevet: **17.02.2016**
(21) Numéro de dépôt: 13717213.6
(22) Date de dépôt: 03.04.2013
(51) Int. Cl.: H01L 31/18, H01L 31/068

(54) **PROCEDE DE FABRICATION D'UNE CELLULE PHOTOVOLTAIQUE A CONTACTS INTERDIGITES EN FACE ARRIERE**
VERFAHREN ZUR HERSTELLUNG EINER FOTOVOLTAIKZELLE MIT INEINANDERGREIFENDEN KONTAKTEN AUF DER RÜCKSEITE
METHOD FOR PRODUCING A PHOTOVOLTAIC CELL WITH INTERDIGITATED CONTACTS IN THE REAR FACE

(30) Priorité: 03.04.2012 FR 1253058
(43) Date de publication de la demande: 11.02.2015
(73) Titulaire: Commissariat à l'Énergie Atomique et aux Énergies Alternatives, 75015 Paris (FR)
(72) Inventeur: GALL, Samuel, F-56610 Arradon (FR)
(74) Mandataire: Regimbeau
(86) Numéro de dépôt international: PCT/EP2013/057031
(87) Numéro de publication internationale: WO 2013/150074

(56) Documents cités:
- EP-A2- 2 161 757
- WO-A2-2011/072153
- JP-A- 2003 124 483
- US-A1- 2007 151 598
- US-A1- 2010 263 722

## Description

### DOMAINE DE L'INVENTION

La présente invention concerne un procédé de fabrication d'une cellule photovoltaïque à contacts interdigités en face arrière.

### ARRIERE PLAN DE L'INVENTION

Les cellules photovoltaïques à contacts interdigités en face arrière (« Interdigitated Back Contact » (IBC) selon la terminologie anglo-saxonne) sont des cellules prometteuses en raison du rendement élevé qu'elles procurent.

De telles cellules comprennent un substrat de silicium dopé recouvert sur sa face avant (c'est-à-dire la face exposée au rayonnement solaire) d'une couche semi-conductrice dopée de même type électrique que le substrat pour former un champ électrique répulsif (« Front Surface Field » (FSF) selon la terminologie anglo-saxonne) en face avant de sorte à repousser les porteurs de charge loin de la surface.

En face arrière, le substrat est recouvert d'une couche semi-conductrice présentant une région dopée de type électrique opposé à celui du substrat pour former la zone émettrice et assurer la collecte des photoporteurs générés par l'illumination de la cellule et une région dopée de même type électrique que le substrat pour former un champ électrique répulsif (« Back Surface Field » (BSF) selon la terminologie anglo-saxonne) en face arrière.

Ces deux régions de la face arrière se présentent généralement sous la forme de deux peignes interdigités.

Des couches de passivation sont formées sur les faces avant et arrière de la cellule.

Par ailleurs, des contacts métalliques sont formés sur chacune des deux régions de la face arrière pour assurer la collecte des charges.

De telles structures sont très performantes en termes de rendement du fait de l'absence d'ombrage en face avant (les lignes métalliques de contact étant uniquement en face arrière) et d'une réduction de la recombinaison en face avant grâce à la présence de la région procurant le champ répulsif FSF.

Le fabricant Sunpower a ainsi démontré que le rendement obtenu par de telles cellules pouvait atteindre 25%.

En revanche, la fabrication de telles cellules est complexe et coûteuse car elle nécessite de nombreuses étapes.

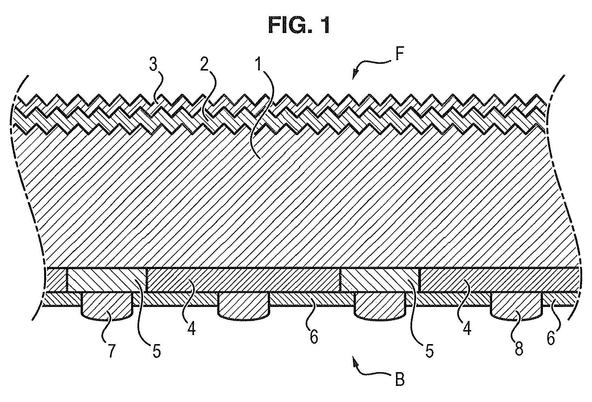

La figure 1 illustre un exemple de cellule photovoltaïque de type IBC.

Cette cellule présente un substrat 1 de silicium, qui, dans cet exemple, est de type n.

Le substrat 1 est recouvert sur sa face avant F d'une couche semi-conductrice 2 dopée n+ formant le champ répulsif FSF.

De manière préférée, ladite couche 2 est formée par diffusion à haute température de POCl₃ à la surface du substrat 1 de silicium.

Ensuite, la couche 2 est recouverte d'une couche de passivation 3, qui présente également des propriétés antireflets, à base de nitrure de silicium (SiNₓ).

Une telle couche est par exemple déposée par dépôt chimique en phase vapeur assisté par plasma (PECVD).

Sur la face arrière B du substrat 1, une région 4 de type p+ constituant l'émetteur est formée par diffusion à haute température de BBr₃ dans le substrat 1 de silicium selon un motif de peigne.

Par ailleurs, une région 5 de type n+ est formée par diffusion à haute température de POCl₃ dans le substrat 1 de silicium selon un motif de peigne complémentaire du motif de la région 4.

Un empilement de couches d'oxyde et de nitrure de silicium (SiO₂/SiNₓ), représenté schématiquement sous la forme d'une couche 6, est ensuite déposé sur l'ensemble de la face arrière pour assurer la passivation des régions dopées.

Des lignes métalliques 7, 8 sont ensuite déposées par sérigraphie sur la face arrière, avec une pâte de sérigraphie à base d'Ag sur les régions n+ et une pâte à base d'Ag/AI sur les régions p+.

Selon un mode de réalisation, la fabrication des régions p+ et n+ 4 et 5 interdigitées requiert des étapes de dépôt de barrières de diffusion, de gravure localisée desdites barrières par des techniques de photolithographie, suivies de la diffusion de BBr₃ et de POCl₃ pour former les régions p+ et n+.

Selon un autre mode de réalisation, la fabrication des régions p+ et n+ 4 et 5 implique des étapes de dépôt de couches dopantes contenant soit du bore soit du phosphore qui sont retirées sélectivement avant le chauffage du substrat pour faire diffuser le dopant dans le substrat 1 de silicium et former ainsi les régions p+ et n+.

Le document WO 2011/072153 A2 décrit un procédé de fabrication d'une cellule photovoltaïque à contacts interdigités en face arrière comprenant la fourniture d'un substrat de silicium dopé; la formation sur la face arrière du substrat d'une couche semi-conductrice dopée avec une première espèce de dopants; la formation, sur la couche semi-conductrice dopée, d'une couche dopante comprenant une seconde espèce de dopants, de type électrique opposé à celui de la première espèce; et, la formation, dans la couche semi-conductrice dopée, d'une région dopée de type opposé à celui de la première espèce, par irradiation sélective d'une région de la couche dopante par un flux lumineux qui provoque la diffusion des dopants de la région irradiée de la couche dopante dans la région sous-jacente de la couche semi-conductrice dopée de sorte à excéder la concentration de la première espèce de dopants.

Par ailleurs, les régions p+ et n+ doivent être isolées électriquement les unes des autres pour éviter tout risque de court-circuit.

Cette isolation électrique peut être réalisée par ablation laser ou en conservant des régions de substrat non dopé entre les régions n+ et p+, au prix d'étapes de dépôt et de gravure supplémentaires.

Il est par ailleurs connu du document US 2010/263722 A1 de séparer les régions de dopage opposé par une région électriquement isolante à base d'un matériau semiconducteur amorphe intrinsèque.

En raison de la complexité de la fabrication des régions n+ et p+ en face arrière, le prix du kW obtenu par ce type de cellules est élevé et peu compétitif par rapport à des cellules photovoltaïques plus répandues de type homojonction, qui sont moins performantes mais sensiblement moins onéreuses.

Pour augmenter la part de marché des cellules de type IBC, il serait donc souhaitable de pouvoir fabriquer les régions n+ et p+ de la face arrière au moyen d'un procédé moins complexe et moins onéreux que les procédés existants.

Un but de l'invention est donc de définir un procédé de fabrication d'une cellule photovoltaïque à contacts interdigités en face arrière qui soit plus simple et moins coûteux que les procédés existants.

### BREVE DESCRIPTION DE L'INVENTION

Conformément à l'invention, il est proposé un procédé de fabrication d'une cellule photovoltaïque à contacts interdigités en face arrière, comprenant :
- la fourniture d'un substrat de silicium dopé,
- la formation, sur la face arrière dudit substrat, d'une couche semi-conductrice dopée avec une première espèce de dopants,
- la formation, sur ladite couche semi-conductrice dopée, d'une couche dite dopante comprenant une seconde espèce de dopants, de type électrique opposé à celui de la première espèce,
- la formation, dans la couche semi-conductrice dopée, d'au moins une région dopée de type électrique opposé à celui de la première espèce, par irradiation sélective d'au moins une région de la couche dopante par un flux lumineux dont la fluence est supérieure à un seuil dit « seuil d'inversion de dopage », au-delà duquel les dopants de la région irradiée de la couche dopante diffusent dans la région sous-jacente de la couche semi-conductrice dopée de sorte à excéder la concentration de la première espèce de dopants,
- la formation, dans la couche semi-conductrice dopée, d'au moins une région électriquement isolante, par irradiation sélective d'au moins une région de la couche dopante par un flux lumineux dont la fluence est comprise dans une gamme dite « gamme de compensation du dopage », inférieure audit seuil d'inversion de dopage, pour laquelle les dopants de la région irradiée de la couche dopante diffusent dans la région sous-jacente de la couche semi-conductrice dopée de sorte à équilibrer les concentrations des deux espèces de dopants dans ladite région, ladite région électriquement isolante étant agencée de sorte à séparer une région de la couche dopée avec la première espèce d'au moins une région dopée de type opposé à celui de la première espèce.

Ladite irradiation sélective est avantageusement effectuée par la face arrière du substrat.

La couche semi-conductrice dopée peut être formée par diffusion à haute température d'un réactif contenant la première espèce de dopant par la face arrière du substrat.

La couche dopante peut être une couche de nitrure de silicium dopée avec la seconde espèce de dopants, déposée par dépôt chimique en phase vapeur assisté par plasma (PECVD).

Selon une forme d'exécution de l'invention, la première espèce de dopants est du même type électrique que celui du substrat.

Par exemple, le substrat est dopé n et la première espèce de dopants est du phosphore.

La couche semi-conductrice dopée peut être formée par diffusion à haute température de POCl₃ par la face arrière du substrat.

La couche dopante peut alors être une couche de nitrure de silicium dopée au bore.

Selon une autre forme d'exécution de l'invention, la première espèce de dopants est du type électrique opposé à celui du substrat.

Par exemple, le substrat est dopé n et la première espèce de dopant est du bore.

La couche semi-conductrice dopée peut être formée par diffusion à haute température de BBr₃ ou de BCl₃ par la face arrière du substrat.

La couche dopante peut être une couche de nitrure de silicium dopée au phosphore.

De manière avantageuse, l'épaisseur de la couche semi-conductrice dopée est comprise entre 100 nm et 1 µm et l'épaisseur de la couche dopante est comprise entre 10 et 300 nm.

Avant la formation de la couche dopante, on forme avantageusement sur la couche semi-conductrice dopée une couche d'oxyde de silicium.

De préférence, la ou les irradiations sélectives sont effectuées au moyen d'un laser.

Par ailleurs, le procédé comprend en outre la formation, sur la face avant dudit substrat, d'une couche semi-conductrice dopée du même type électrique que le substrat, de sorte à former un champ électrique répulsif sur ladite face avant.

Ladite couche de champ électrique répulsif est de préférence formée par diffusion à haute température de POCl₃ dans le substrat.

Un autre objet de l'invention concerne une structure comprenant un substrat de silicium dopé, recouvert successivement d'une couche semi-conductrice dopée avec une première espèce de dopants et d'une couche dite dopante comprenant une seconde espèce de dopants, de type électrique opposé à celui de la première espèce, caractérisée en ce que la couche semi-conductrice dopée comprend au moins une région dopée de type opposé à celui de la première espèce, comprenant des dopants de la seconde espèce en concentration supérieure à celle des dopants de la première espèce, et une région électriquement isolante, comprenant des dopants de la seconde espèce, en concentration équilibrée avec celle des dopants de la première espèce, ladite région électriquement isolante étant agencée de sorte à séparer une région de la couche dopée avec la première espèce d'au moins une région dopée de type opposé à celui de la première espèce.

Enfin, un autre objet de l'invention concerne une cellule photovoltaïque à contacts interdigités en face arrière, comprenant un substrat de silicium dopé, et, sur la face arrière dudit substrat, une alternance, sous la forme d'un peigne interdigité, de régions dopées p+ et de régions dopées n+, ladite cellule étant caractérisée en ce que l'ensemble desdites régions p+ et n+ présente une concentration sensiblement homogène en dopants d'une même espèce et en ce que ladite cellule comprend en outre, sur la face arrière du substrat, une pluralité de régions électriquement isolantes séparant les régions dopées p+ et les régions dopées n+, lesdites régions électriquement isolantes présentant une concentration en dopants de ladite espèce sensiblement homogène à celle des régions dopées p+ et des régions dopées n+.

### BREVE DESCRIPTION DES DESSINS

D'autres caractéristiques et avantages de l'invention ressortiront de la description détaillée qui va suivre, en référence aux dessins annexés sur lesquels :
- la figure 1 illustre la structure d'une cellule photovoltaïque à contacts interdigités en face arrière,
- les figures 2A à 2C illustrent des étapes du procédé selon un mode de réalisation de l'invention,
- la figure 3 présente l'évolution de la résistance Rsheet d'une couche initialement dopée au bore en fonction de la fluence d'irradiation par une source laser d'une couche dopante de SiN(P) déposée sur ladite couche dopée,
- la figure 4 présente, pour différentes fluences d'irradiation, les profils de concentration en bore et en phosphore dans ladite couche initialement dopée au bore,
- la figure 5 présente l'évolution de la résistance Rsheet d'une couche initialement dopée au phosphore en fonction de la fluence d'irradiation par une source laser d'une couche dopante de SiN(B) déposée sur ladite couche dopée,
- la figure 6 présente, pour différentes fluences d'irradiation, les profils de concentration en bore et en phosphore dans ladite couche initialement dopée au phosphore,
- les figures 7A à 7C illustrent des étapes d'un exemple de mise en oeuvre de l'invention.

### DESCRIPTION DETAILLEE DE L'INVENTION

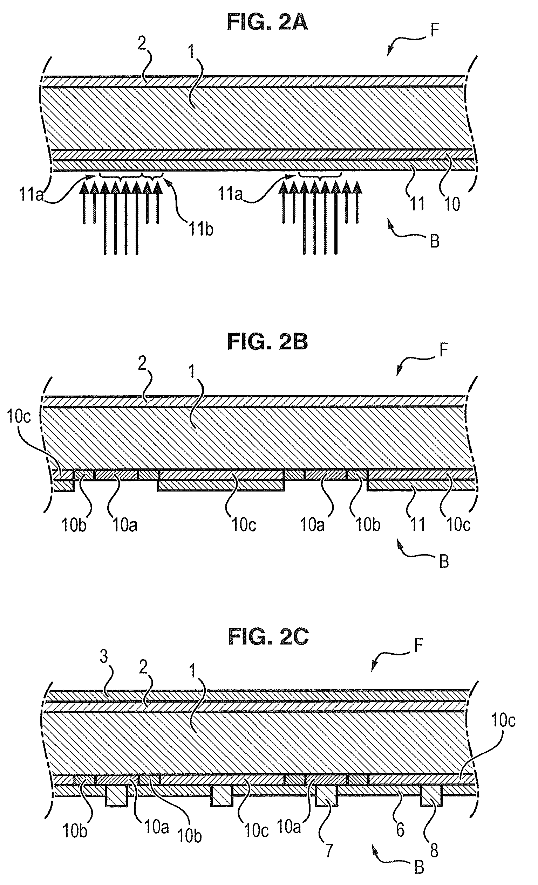

Les étapes du procédé selon un mode de réalisation de l'invention sont illustrées de manière schématique aux figures 2A à 2C.

En référence à la figure 2A, on forme dans un substrat 1 de silicium dopé la couche 2 formant le champ répulsif FSF en face avant et une couche dopée 10 en face arrière.

Dans l'exemple, le substrat est de type n mais il pourrait en variante être de type p.

Le dopage de ce substrat doit avantageusement permettre d'avoir des bonnes durées de vie (temps entre la création des paires électron/trou et leur recombinaison), typiquement supérieure à 700 µs, ce qui correspond à des résistivités comprises entre 14 et 22 ohm.cm.

Ce substrat peut être obtenu par toute technique de croissance connue (par exemple de type float zone, ou par tirage Czochralski...).

La couche 2 est dopée de même type électrique que le substrat 1, mais avec un niveau de dopage plus important (n+ ou n++).

La couche 2 présente de préférence une résistance de type RSheet (« Sheet Resistance » selon la terminologie anglo-saxonne) de l'ordre de 70 à 100 ohm/carré.

Dans un mode particulier de réalisation de l'invention, la couche 2 est formée dans le substrat avant la couche dopée 10.

La formation de ladite couche FSF est connue de l'homme du métier et ne sera donc pas décrite en détail ici.

Par exemple, on peut former la couche 2 par diffusion à haute température de BCl₃ ou de BBr₃ par la face avant du substrat 1.

De manière alternative, on peut également effectuer une implantation ionique de phosphore à travers la face avant F du substrat 1, suivie d'un recuit d'activation.

On dépose ensuite une couche de protection (non représentée) sur la couche 2.

Ladite couche peut par exemple consister en une couche de 200 nm de dioxyde de silicium déposé par PECVD à 450°C.

On forme ensuite sur la face arrière B du substrat une couche semi-conductrice dopée 10 avec une première espèce de dopants.

Selon une première forme d'exécution de l'invention, les dopants de cette première espèce sont du même type électrique que celui du substrat 1.

De manière avantageuse, la première espèce de dopants est du bore ; la couche 10 est alors dopée de type p+.

Le niveau de dopage de ladite couche de type p+ est tel que la résistance Rsheet est de l'ordre de 50 et 100 ohm/carré.

Selon une seconde forme d'exécution de l'invention, les dopants de cette première espèce sont de type opposé à celui du substrat 1.

L'invention permet en effet une grande souplesse sur le choix du premier dopage à réaliser.

Dans ce second cas (qui est décrit en détail dans un exemple ci-dessous), il est alors possible de former simultanément la couche 2 en face avant et la couche dopée 10 en face arrière du substrat.

De manière avantageuse, la première espèce de dopants est du phosphore ; la couche 10 est alors dopée de type n+.

La couche semi-conductrice dopée 10 (et, le cas échéant, la couche 2 si elle est formée dans la même étape) est de préférence formée par diffusion à haute température d'un réactif contenant la première espèce de dopant par la face arrière B du substrat 1.

La diffusion à haute température est une technique connue en elle-même et l'homme du métier est en mesure de définir les réactifs et les conditions opératoires pour former la couche dopée 10 soit de type n+, soit de type p+.

La diffusion s'effectue à haute température, typiquement entre 750° et 950°.

Pour former la couche dopée 10 de type p+ dans le substrat 1 de type n, on diffuse à haute température du bore à partir de BCl₃ ou de BBr₃ par la face arrière B du substrat, la face avant étant protégée par la couche de protection mentionnée plus haut.

En général, pour former la couche dopée 10 de type n+ dans le substrat 1 de type n, on diffuse à haute température du phosphore à partir de POCl₃ par la face arrière B du substrat.

Comme indiqué plus haut, il est possible de former dans une même étape la couche 2 et la couche 10, si elles sont de même type électrique.

Lors de l'étape de diffusion à haute température, il se forme un verre de phosphore (dans le cas de la diffusion à partir de POCl₃) ou de bore (dans le cas de la diffusion à partir de BCl₃ ou BBr₃).

Ce verre peut être retiré par un traitement chimique approprié.

La couche semi-conductrice dopée 10 peut être formée à partir d'autres techniques, par exemple par sputtering (évaporation) ou encore par spin on (dépôt à la tournette), par dépôt PECVD, dépôt PVD, etc. en présence des dopants (par exemple sous forme de phosphine PH3 ou de triméthylborate TMB)

On forme ensuite, sur la couche semi-conductrice dopée 10, une couche dopante 11 de type électrique opposé à celui de la couche dopée 10.

Ainsi, si la couche semi-conductrice dopée 10 est de type p+, la couche dopante 11 est dopée au bore.

Si la couche semi-conductrice dopée 10 est de type n+, la couche dopante 11 est dopée au phosphore.

La couche dopante est de préférence une couche de nitrure de silicium (de formule générale SiNx).

Il peut s'agir également d'une couche d'oxyde de silicium (de formule générale SiOx, par exemple SiO₂) ou d'un oxyde transparent conducteur (comme l'ITO) ou encore d'un empilement de telles couches.

Cette couche dopante peut éventuellement être déposée sur une fine couche d'oxyde de silicium (typiquement inférieure à 10nm, et de l'ordre de 4 à 6 nm) qui pourra à terme être conservée et servir de couche de passivation de la structure. Il pourra s'agir par exemple d'un oxyde thermique ou déposé.

La couche dopante 11 est avantageusement formée par dépôt, par exemple de type PECVD, sur la couche semi-conductrice dopée 10, en introduisant dans l'enceinte de dépôt un gaz contenant l'élément dopant souhaité (par exemple de la phosphine PH3 pour obtenir un dopage phosphore ou du TMB pour obtenir un dopage bore).

D'autres techniques de dépôt sont bien sûr possible.

Par exemple, on pourra réaliser par croissance thermique de l'oxyde de silicium (pour former la couche de passivation) et poursuivre le traitement thermique en injectant le dopant souhaité (par exemple de la phosphine) pour obtenir l'oxyde dopé formant la couche dopante.

On met ensuite en oeuvre une irradiation sélective, c'est-à-dire limitée à des régions prédéfinies, de la face arrière B du substrat par une source laser.

L'irradiation d'une région de la couche dopante a pour effet de faire diffuser des atomes dopants de ladite couche dans la région sous-jacente de la couche semi-conductrice dopée.

Plus précisément, l'irradiation entraîne une fusion du silicium de la couche semi-conductrice à l'interface avec la couche dopante ; les atomes dopants diffusent alors dans cette phase liquide et sont activés électriquement lors de la recristallisation du silicium.

On parle dans la suite du présent texte de « dopage laser ».

Or, il a été mis en évidence trois régimes de diffusion en fonction de la fluence de la source laser.

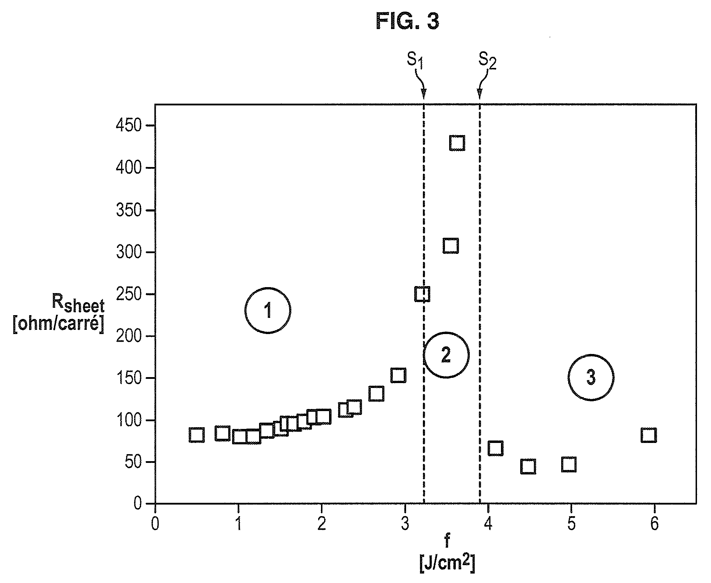

La figure 3 illustre la variation de la résistance Rsheet (exprimée en ohm/carré) dans une couche 10 dopée au bore, sur laquelle une couche dopante 11 de SiN(P) a été déposée et irradiée par une source laser, en fonction de la fluence f (exprimée en J/cm²) de ladite source.

Dans le cas de cette expérience, ladite couche semi-conductrice 10 dopée p+ est formée par diffusion à haute température de BCl₃ à 940°C pendant 30 minutes, procurant une résistance Rsheet de 60 ohm/carré, puis partiellement gravée par une solution chimique pendant 10 minutes, de sorte à ajuster sa résistance Rsheet pour qu'elle atteigne 90 ohm/carré.

Cette étape de gravure est optionnelle et peut être omise si la couche semi-conductrice dopée directement issue de la diffusion à haute température présente la résistance Rsheet souhaitée.

La couche dopante 11 est déposée sur la couche semi-conductrice dopée ainsi gravée par une technique de PECVD à 300°C avec des gaz précurseurs SiH₄, NH₃ et 50 sccm de PH₃.

La source laser est ici de type excimère, avec une longueur d'onde de 308 nm, une durée d'impulsion de 150 ns et une fréquence de 100Hz.

Dans un premier régime (région 1 du graphe), compris entre une fluence nulle et un premier seuil S1 de fluence qui, pour cette source, est de 3 J/cm², la résistance initiale de la couche dopée 10 (émetteur p+) augmente légèrement de 90 à 150 ohm/carré.

Dans un deuxième régime (région 2), compris entre le premier seuil S1 et un second seuil S2 qui, pour cette source, est de 4 J/cm², on observe une très forte augmentation de la résistance, qui atteint des valeurs supérieures à 450 ohm/carré.

Cette forte augmentation traduit une compensation de la couche semi-conductrice dopée 10, c'est-à-dire une concentration équilibrée entre atomes de bore et de phosphore électriquement actifs. Un dopant est actif électriquement quand il vient se placer en site substitutionnel dans le cristal de silicium. Il n'est pas électriquement actif quand il vient se placer en site interstitiel. Lorsque l'on mentionne une concentration en dopant dans le présent texte, on se réfère à la concentration de dopants actifs.

La couche 10, initialement dopée p+, a ainsi été transformée en une couche électriquement isolante, typiquement avec une résistance Rsheet supérieure à 200 ohm/carré.

Le régime compris entre les seuils S1 et S2 peut alors être qualifié de « gamme de compensation du dopage ».

Enfin, le troisième régime (région 3), qui correspond à une fluence supérieure au seuil S2, la résistance diminue fortement pour atteindre des valeurs inférieures à 50 ohm/carré.

Cette diminution traduit le fait que les atomes de phosphore de la couche dopante 11 ont diffusé massivement dans la couche semi-conductrice dopée 10, de sorte que la concentration en atomes de bore de la couche dopée 10 devient négligeable (typiquement avec au moins un facteur 10 en terme de concentration) devant la concentration en atomes de phosphore.

La couche 10, initialement dopée p+, a ainsi été transformée en couche dopée n+.

Le second seuil S2 peut alors être qualifié de « seuil d'inversion de dopage ».

Les niveaux de dopages identifiés dans les trois régimes mentionnés ci-dessus sont confirmés par les analyses des profils des dopants P et B dans la couche dopée mesurés par SIMS (spectrométrie de masse à ionisation secondaire).

Les profils SIMS donnent la concentration totale de dopants (électriquement actifs et inactifs).

Néanmoins, comme la majorité des dopants sont électriquement actifs, le profil SIMS est un bon indicateur de l'inversion de concentration.

Ces résultats ont par ailleurs été confirmés par des mesures ECV (« Electrochemical Capacitance Voltage »), mesures qui ne donnent que la concentration en dopants actifs.

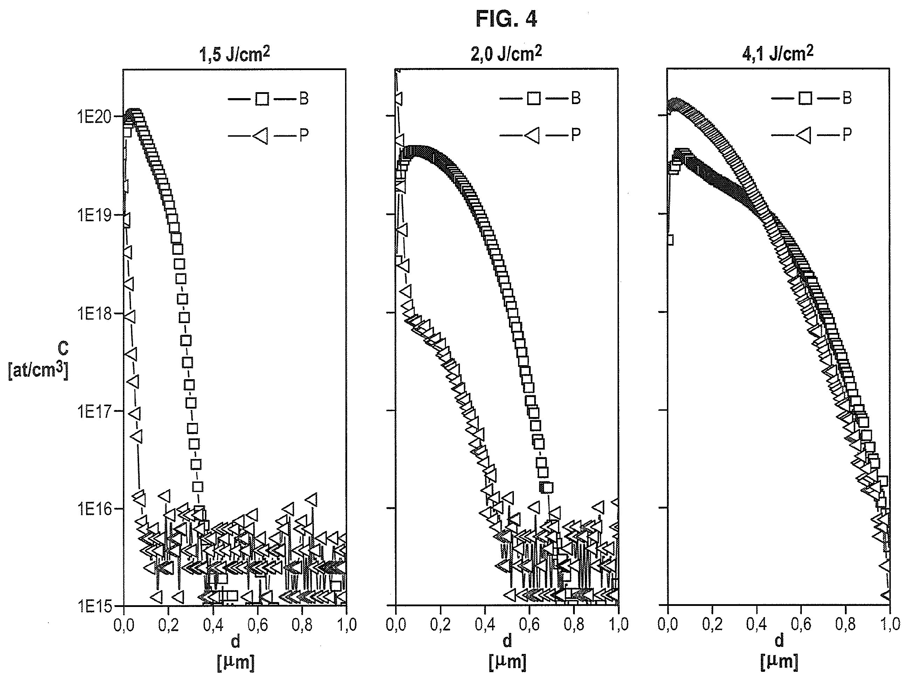

Les graphes (a) à (c) de la figure 4 présentent les profils de bore et de phosphore (concentrations exprimées en at/cm³) en fonction de la profondeur d (exprimée en µm) dans la couche semi-conductrice dopée 10 après irradiation de la couche dopante 11 à des fluences respectives de 1,5, 2,0 et 4,1 J/cm².

Sur le graphe (a), correspondant à une fluence de 1,5 J/cm², le profil B présente une concentration de surface de 1E20 at/cm³ et une profondeur de 400 nm alors qu'un profil P est visible avec une concentration de surface d'environ 5E19 at/cm³ et une profondeur de 75 nm.

Sur le graphe (b), correspondant à une fluence de 2,0 J/cm², le profil initial de B a été modifié avec une concentration de surface de 5E19 at/cm³ et une profondeur de 700 nm. Le profil de P est plus marqué avec une profondeur de 400 nm.

Sur le graphe (c), correspondant à une fluence de 4,1 J/cm², le profil de P est très marqué avec une concentration de surface de 1E20 at/cm3 et une profondeur de 1 µm alors que le profil de B présente une concentration de surface de 3.5E19 at/cm³ et une profondeur de 1 µm.

Ces courbes confirment donc les mécanismes de compensation de la couche initialement dopée au bore par la diffusion laser du phosphore à partir de la couche dopante de SiN(P).

Naturellement, la valeur des seuils de fluence S1 et S2 dépend de la nature de la source laser.

Par ailleurs, ce phénomène peut être observé avec d'autres lasers de type excimères (typiquement dans la gamme de longueur d'onde de 193 à 308 nm et avec des durées d'impulsion de 15 à 300 ns).

On a observé également ce phénomène pour un laser Yag (355 nm, durée d'impulsion 15 ps, 80 MHz).

Dans ce cas, le seuil de compensation en puissance a été évalué entre 4,5 et 6,5W (la fluence étant la puissance divisée par la taille du spot et la fréquence de pulse).

Par ailleurs, le phénomène de compensation et d'inversion du dopage est également observé lorsque la couche semi-conductrice dopée 10 est de type n+ et que la couche dopante 11 contient des dopants de type électrique opposé.

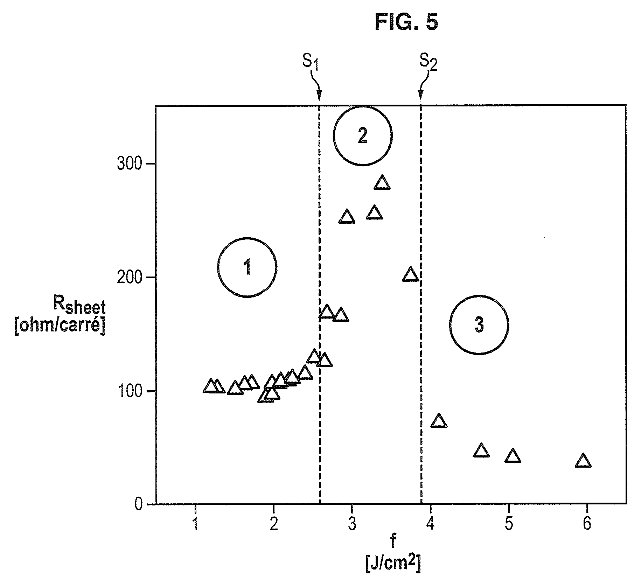

La figure 5 illustre ainsi la variation de la résistance Rsheet (exprimée en ohm/carré) dans une couche semi-conductrice 10 dopée au phosphore, sur laquelle une couche dopante 11 de SiN(B) a été déposée et irradiée par une source laser, en fonction de la fluence f (exprimée en J/cm²) de ladite source.

Ladite couche semi-conductrice 10 dopée n+ est formée par diffusion à haute température de POCl₃ à 830°C pendant 30 minutes, puis gravée par une solution chimique pendant 10 minutes, de sorte à présenter une résistance Rsheet de 100 ohm/carré.

La couche dopante 11 est déposée sur la couche semi-conductrice dopée ainsi gravée par une technique de PECVD à 300°C avec des gaz précurseurs SiH₄, NH₃ et 50 sccm de TMB.

La source laser est ici de type excimère, avec une longueur d'onde de 308 nm, une durée d'impulsion de 150 ns et une fréquence de 100Hz.

Dans le premier régime (région 1 du graphe), compris entre une fluence nulle et un premier seuil S1 de fluence qui, pour cette source, est de 2,6 J/cm², la résistance initiale de la couche dopée 10 (émetteur p+) augmente légèrement de 100 à 150 ohm/carré.

Dans le deuxième régime (région 2), ou gamme de compensation du dopage, qui est compris entre le premier seuil S1 et un second seuil S2 qui, pour cette source, est de 3,9 J/cm², on observe une très forte augmentation de la résistance, qui atteint des valeurs de l'ordre de 300 ohm/carré.

Cette forte augmentation traduit une compensation de la couche semi-conductrice dopée 10, c'est-à-dire une concentration équilibrée entre atomes de bore et de phosphore.

La couche semi-conductrice 10, initialement dopée n+, a ainsi été transformée en une couche électriquement isolante.

Enfin, le troisième régime (région 3), dit d'inversion de dopage, qui correspond à une fluence supérieure au seuil S2, la résistance diminue fortement pour atteindre des valeurs inférieures à 50 ohm/carré.

La couche semi-conductrice 10, initialement dopée n+, a ainsi été transformée en couche dopée p+.

Les niveaux de dopages identifiés dans les trois régimes mentionnés ci-dessus sont confirmés par les analyses des profils des dopants P et B dans la couche semi-conductrice dopée mesurés par SIMS (spectrométrie de masse à ionisation secondaire).

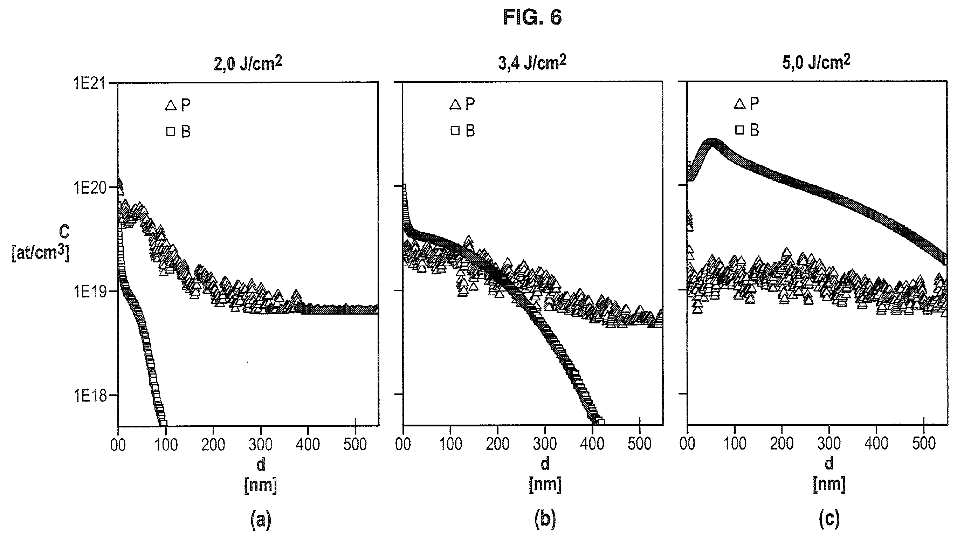

Les graphes (a) à (c) de la figure 6 présentent les profils de bore et de phosphore (concentrations exprimées en at/cm³) en fonction de la profondeur d (exprimée en nm) dans la couche dopée 10 après irradiation de la couche dopante 11 à des fluences respectives de 2,0, 3,4 et 5,0 J/cm².

Sur le graphe (a), correspondant à une fluence de 2,0 J/cm², le profil B présente une concentration de surface de 1E20 at/cm³ et une profondeur de 100 nm alors qu'un profil P est visible avec une concentration de surface d'environ 1E19 at/cm³ et une profondeur de 500 nm.

Sur le graphe (b), correspondant à une fluence de 3,4 J/cm², incluse dans la gamme de compensation du dopage, le profil initial de B a été modifié avec une concentration de surface de 1^{E}20 at/cm³ et une profondeur de 400 nm.

Sur le graphe (c), correspondant à une fluence de 5,0 J/cm², c'est-à-dire supérieure au seuil d'inversion du dopage, le profil de B est très marqué avec une concentration de surface de 1E20 at/cm³ et une profondeur de 500 nm alors que le profil de P présente une concentration de surface de 1 E19 at/cm³ et une profondeur de 500 nm.

Ces courbes confirment donc les mécanismes de compensation de la couche semi-conductrice initialement dopée au phosphore par la diffusion laser du bore à partir de la couche dopante de SiN(B).

De manière particulièrement avantageuse, on met à profit le phénomène d'inversion du dopage mis en évidence ci-dessus pour former, dans la couche semi-conductrice dopée 10, des régions présentant un dopage de type opposé.

A cet effet, on irradie à l'aide d'une source laser présentant une fluence supérieure au seuil S2 d'inversion du dopage, des régions 11a de la couche dopante correspondant aux régions 10a de la couche semi-conductrice dopée 10 dont on souhaite inverser le type électrique de dopage.

Sur la figure 2A, cette irradiation est schématisée par les flèches les plus longues.

Ainsi, dans la première forme d'exécution envisagée, si la couche semi-conductrice dopée 10 est de type p+, l'irradiation de régions 11a de la couche dopante 11 de SiN(P) avec une fluence supérieure au seuil S2 a pour effet de former dans la couche semi-conductrice dopée 10 des régions 10a dopées n+.

Dans la seconde forme d'exécution envisagée, où la couche semi-conductrice dopée 10 est de type n+, l'irradiation de la couche dopante 11 de SiN(B) avec une fluence supérieure au seuil S2 a pour effet de former dans la couche semi-conductrice dopée 10 des régions 10a dopées p+.

Selon un mode de réalisation préféré de l'invention, on met également à profit le phénomène de compensation du dopage pour former, dans la couche semi-conductrice dopée 10, des régions électriquement isolantes permettant d'isoler électriquement les régions n+ formant le champ électrique répulsif en face arrière des régions p+ constituant l'émetteur.

A cet effet, on irradie à l'aide d'une source laser présentant une fluence comprise dans la gamme [S1, S2] de compensation du dopage, des régions 11 b de la couche dopante correspondant aux régions 10b de la couche semi-conductrice dopée 10 que l'on souhaite rendre électriquement isolantes.

Sur la figure 2A, cette irradiation est schématisée par les flèches les plus courtes.

En variante, l'isolation peut être obtenue par d'autres techniques, par exemple par ablation laser, en enlevant localement la couche semi-conductrice dopée 10.

On veillera dans ce cas à ce que l'ablation laser ne génère pas d'effet thermique (qui entrainerait un dopage par la couche dopante).

On peut utiliser pour cela par exemple un laser UV à faible durée d'impulsion et faible fréquence, par exemple un laser à 355 nm, de durée d'impulsion de 15 ps et de fréquence 200 Khz.

Dans la cellule photovoltaïque finale, on obtient donc dans la couche semi-conductrice dopée 10 trois régions de type électrique différent.

Dans la première forme d'exécution envisagée, où la couche semi-conductrice dopée 10 est initialement de type p+, les régions 10a, de type n+, formeront donc le champ électrique répulsif en face arrière, tandis que les régions 10c non affectées par le dopage laser constitueront l'émetteur p+, lesdites régions 10a et 10c étant séparées par les régions 10b électriquement isolantes.

Dans la seconde forme d'exécution envisagée, où la couche semi-conductrice dopée 10 est initialement de type n+, les régions 10a, de type p+, formeront donc l'émetteur, tandis que les régions 10c non affectées par le dopage laser formeront le champ électrique répulsif en face arrière, +, lesdites régions 10a et 10c étant séparées par les régions 10b électriquement isolantes.

Le motif des différentes régions (n+, p+ et isolantes) est typiquement celui d'un peigne interdigité, c'est-à-dire une alternance répétitive de bandes p+ / isolante / n+ / isolante).

Par exemple, les régions n+ présentent une largeur de l'ordre de 300 µm, les régions électriquement isolantes présentent une largeur de l'ordre de 100 µm, et les régions p+ présentent une largeur comprise entre 600 et 1000 µm.

On adapte donc la largeur d'irradiation en fonction de la nature finale de la région traitée.

Une particularité d'une cellule fabriquée par le dopage laser selon l'invention est que l'ensemble des régions p+, n+ et isolantes de la face arrière du substrat comprennent toutes une concentration sensiblement homogène en dopants de la première espèce.

En effet, même si le dopage laser a eu pour effet, selon la fluence d'irradiation, de compenser ou d'inverser le dopage de certaines régions de la couche semi-conductrice dopée 10, les dopants de la première d'espèce présents initialement dans ladite couche y sont toujours présents.

La concentration de la première espèce de dopants est susceptible d'évoluer légèrement par diffusion lors de l'irradiation par le laser ; néanmoins, on observe une concentration en dopants de la première espèce sensiblement homogène dans les régions p+, n+ et isolantes.

Dans une première variante, après la ou les irradiations, on retire par gravure chimique la couche dopante 11 résiduelle, l'irradiation pouvant avoir localement éliminé tout ou partie de la couche dopante au niveau des zones irradiées.

Ensuite, de manière connue en elle-même, on forme une couche de passivation 3, 6 respectivement sur la face avant et sur la face arrière du substrat 1.

Par exemple, la couche de passivation peut comprendre une première couche de SiO₂ thermique, présentant une épaisseur comprise entre 5 et 20 nm, et une seconde couche de SiNx déposée par PECVD présentant une épaisseur comprise entre 50 et 150 nm.

Enfin, on dépose des contacts métalliques 7 et 8 par sérigraphie sur les régions émettrices p+ (pâte d'Ag) et sur les régions de champ électrique répulsif n+ (pâte d'Ag/AI).

Un recuit dans un four à infra-rouge permet de prendre le contact entre le silicium de ces régions et le métal des contacts.

Dans une deuxième variante, la couche dopante peut être une couche de SiNx déposée sur une première couche mince d'oxyde de silicium, par exemple de 6 nm. Eventuellement une deuxième couche mince d'oxyde de silicium peut être prévue sur la couche de SiNx, pour à terme assurer le confinement optique de la cellule.

On procède selon l'invention à la réalisation des zones dopées de type opposé à celui de la couche semi-conductrice dopée, par une irradiation laser adaptée, les couches d'oxyde présentes sont suffisamment fines pour ne pas gêner le mécanisme.

On procède à la réalisation également des zones isolantes par exemple par irradiation laser à plus faible fluence.

Il n'est alors pas nécessaire de retirer la couche dopante de SiN qui peut être utilisée en association avec la couche d'oxyde sous-jacente comme couche de passivation.

On peut alors directement former les contacts métalliques 7 et 8 par exemple par sérigraphie comme précédemment.

En variante il est possible qu'au niveau des zones irradiées la fluence soit suffisamment importante pour entrainer également l'ablation du multicouche de surface SiO₂/SiN.

On peut alors envisager au niveau de ces cavités de réaliser les contacts par d'autres techniques, par exemple par dépôt électrolytique.

On pourra se référer pour plus d'information sur cette technique à l'article de Aleman et al, « Advances in Electroless Nickel Plating for the Metallization of Silicon Solar Cells using different Structuring Techniques for the ARC », 24th European Photovoltaic Solar Energy Conference, 21-25 Sept. 2009, Hamburg.

On pourra éventuellement, avant de réaliser ce dépôt, ouvrir des zones de reprises de contact au niveau de la zone dopée de type opposée à celle au niveau de la zone irradiée, par exemple par ablation laser.

On veillera dans ce cas à ce que l'ablation laser ne génère pas d'effet thermique (qui entraînerait un dopage).

On peut utiliser pour cela par exemple un laser UV à faible durée d'impulsion et faible fréquence, par exemple un laser à 355 nm, de durée d'impulsion de 15 ps, de fréquence de 200 Khz.

Dans ce cas, on pourra réaliser simultanément les métallisations sur les régions n+ et p+ par dépôt électrolytique.

### Exemple de mise en oeuvre de l'invention

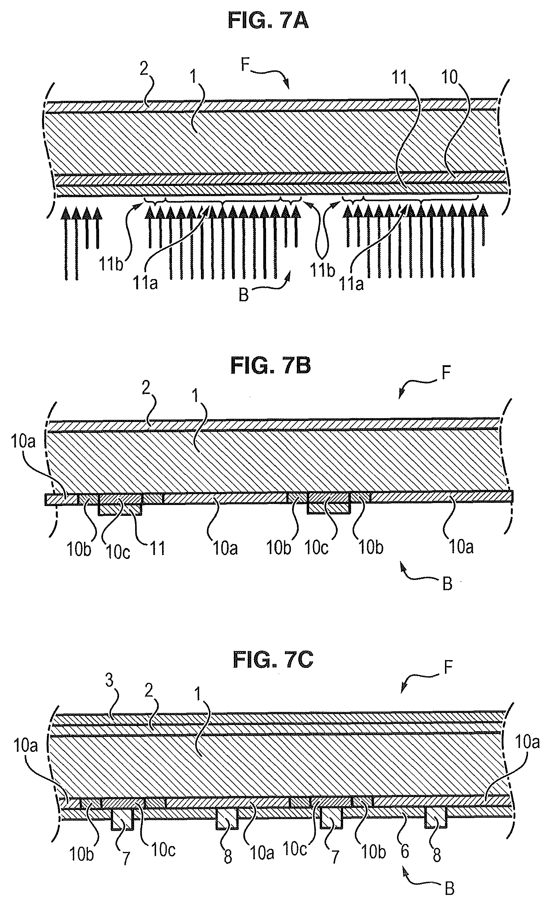

Un exemple détaillé de mise en oeuvre de l'invention est décrit en référence aux figures 7A à 7C.

Dans une première étape (non illustrée), on prépare un substrat 1 de silicium dopé N, en retirant la zone écrouie et en polissant les deux faces F et B du substrat par exemple par un traitement chimique de type CP133, c'est-à-dire un mélange de HF, HNO₃ et de CH₃COOH dans les proportions 1:3:3.

On dépose ensuite une couche protectrice (non illustrée) sur la face arrière B du substrat 1.

Ladite couche a pour fonction de protéger la face arrière B du substrat pendant une étape ultérieure de texturation de la face avant F.

La couche protectrice peut par exemple consister en une couche de 200 nm de dioxyde de silicium déposé par PECVD.

La face arrière étant protégée, on met en oeuvre une texturation de la face avant, par exemple au moyen d'une gravure chimique. Typiquement, cette gravure est réalisée à partir d'hydroxyde de potassium (KOH) à 1%, pendant 40 minutes à 80°C.

Cette gravure a pour effet de conférer à la face avant F une surface non plane mais présentant des reliefs, par exemple de type pyramide (non schématisés ici).

On retire ensuite la couche protectrice en face arrière, au moyen d'une attaque sélective par de l'acide fluorhydrique (HF) à 2%.

En référence à la figure 7A, on met ensuite en oeuvre une diffusion à haute température de POCl₃ à 830°C pendant 30 minutes.

On forme ainsi simultanément une couche 2 de type n+ sur la face avant F du substrat 1 (ladite couche 2 formant le champ répulsif FSF) et une couche semi-conductrice 10 dopée de type n+ sur la face arrière B du substrat.

Un traitement à base d'acide fluorhydrique permet de retirer le verre de phosphore qui s'est formé pendant la diffusion.

On effectue un dépôt par PECVD d'une couche dopante 11 de 80 nm de SiN dopé au bore.

A cet effet, pendant le dépôt de ladite couche, on injecte un flux de 50 sccm de TMB.

On effectue ensuite une première irradiation laser (schématisée par les flèches les plus longues) de la face arrière B du substrat 1 à une longueur d'onde de 308 nm avec des impulsions de 150 ns et une fluence de 4,5 J/cm², localisée à des bandes 11a de 600 µm de large selon un motif de peigne.

Comme on peut le voir sur la figure 6(c), cette fluence est supérieure au seuil d'inversion de dopage.

Par conséquent, les atomes de bore des bandes irradiées 11a de la couche dopante 11 diffusent dans les bandes 10a sous-jacentes de la couche semi-conductrice dopée 10 de sorte à excéder la concentration des atomes de phosphore.

Comme illustré à la figure 7B, on forme ainsi, dans les bandes 10a de la couche dopée 10, des régions émettrices de type p++.

On effectue également une irradiation laser (schématisée par les flèches les plus courtes) de la face arrière B du substrat 1 à une longueur d'onde de 308 nm avec des impulsions de 150 ns et une fluence de 3,2 J/cm², localisée à des bandes 11 b de 100 µm de large adjacentes aux bandes 10a de type p++ formées précédemment.

Comme on peut le voir à la figure 6(b), cette fluence est comprise dans la gamme de compensation du dopage.

Par conséquent, les atomes de bore des bandes irradiées 11 b de la couche dopante 11 diffusent dans les bandes 10b sous-jacentes de la couche semi-conductrice dopée 10 de sorte à équilibrer les concentrations des atomes de bore et de phosphore dans lesdites bandes 10b.

Comme illustré à la figure 7B, on forme ainsi, dans les bandes 10b de la couche dopée 10, des régions électriquement isolantes qui isolent les régions 10a émettrices p++ des régions 10c restantes BSF de type n+.

On retire ensuite par voie chimique les parties de la couche dopante 11 qui n'ont pas été irradiées.

En référence à la figure 7C, on met ensuite en oeuvre une oxydation thermique du substrat, dans une atmosphère d'oxygène à 950°C pendant 30 minutes, de manière à former une couche de 10 nm d'oxyde.

On dépose par PECVD une couche de SiNx de 60 nm sur la face avant F et de 100 nm sur la face arrière B, de manière à obtenir des couches de passivation respectives 3 et 6.

On dépose ensuite par sérigraphie, selon un motif de peigne centré sur les régions BSF 10c, une pâte d'argent présentant une largeur de 100 µm, de manière à former des contacts 7.

On dépose également par sérigraphie, selon un motif de peigne centré sur les régions émettrices 10a, une pâte d'argent/aluminium présentant une largeur de 300 µm, de manière à former des contacts 8.

Enfin, on met en oeuvre un recuit des contacts dans un four à 890°C.

Il va de soi que cet exemple est donné à titre purement illustratif et que la portée de l'invention n'est pas limitée à ce mode de réalisation particulier.

## Revendications

1. Procédé de fabrication d'une cellule photovoltaïque à contacts interdigités en face arrière, **caractérisé en ce qu'**il comprend :
- la fourniture d'un substrat (1) de silicium dopé,
- la formation, sur la face arrière (B) dudit substrat (1), d'une couche semi-conductrice dopée (10) avec une première espèce de dopants,
- la formation, sur ladite couche semi-conductrice dopée (10), d'une couche dite dopante (11) comprenant une seconde espèce de dopants, de type électrique opposé à celui de la première espèce (10),
- la formation, dans la couche semi-conductrice dopée (10), d'au moins une région (10a) dopée de type opposé à celui de la première espèce, par irradiation sélective d'au moins une région (11a) de la couche dopante (11) par un flux lumineux dont la fluence est supérieure à un seuil (S₂), dit « seuil d'inversion de dopage », au-delà duquel les dopants de la région irradiée (11a) de la couche dopante (11) diffusent dans la région (10a) sous-jacente de la couche semi-conductrice dopée (10) de sorte à excéder la concentration de la première espèce de dopants
- la formation, dans la couche semi-conductrice dopée (10), d'au moins une région (10b) électriquement isolante, par irradiation sélective d'au moins une région (11b) de la couche dopante (11) par un flux lumineux dont la fluence est comprise dans une gamme ([S₁-S₂]), dite « gamme de compensation du dopage », inférieure audit seuil (S₂) d'inversion de dopage, pour laquelle les dopants de la région irradiée (11 b) de la couche dopante (11) diffusent dans la région (10b) sous-jacente de la couche semi-conductrice dopée (10) de sorte à équilibrer les concentrations des deux espèces de dopants dans ladite région (10b), ladite région (10b) électriquement isolante étant agencée de sorte à séparer une région (10c) de la couche (10) dopée avec la première espèce d'au moins une région (10a) dopée de type opposé à celui de la première espèce.

2. Procédé selon la revendication 1, **caractérisé en ce que** ladite irradiation sélective est effectuée par la face arrière (B) du substrat (1).

3. Procédé selon l'une des revendications 1 à 2, **caractérisé en ce que** la couche dopée (10) est formée par diffusion à haute température d'un réactif contenant la première espèce de dopant par la face arrière (B) du substrat (1).

4. Procédé selon l'une des revendications 1 à 3, **caractérisé en ce que** la couche dopante (11) est une couche de nitrure de silicium dopée avec la seconde espèce de dopants, déposée par dépôt chimique en phase vapeur assisté par plasma (PECVD).

5. Procédé selon l'une des revendications 1 à 4, **caractérisé en ce que** la première espèce de dopants est du même type électrique que celui du substrat (1).

6. Procédé selon la revendication 5, **caractérisé en ce que** le substrat (1) est dopé n et **en ce que** la première espèce de dopants est du phosphore.

7. Procédé selon la revendication 6, **caractérisé en ce que** la couche semi-conductrice dopée (10) est formée par diffusion à haute température de POCl₃ par la face arrière du substrat (1).

8. Procédé selon l'une des revendications 5 à 7, **caractérisé en ce que** la couche dopante (11) est une couche de nitrure de silicium dopée au bore.

9. Procédé selon l'une des revendications 1 à 4, **caractérisé en ce que** la première espèce de dopants est du type électrique opposé à celui du substrat (1).

10. Procédé selon la revendication 9, **caractérisé en ce que** le substrat (1) est dopé n et **en ce que** la première espèce de dopant est du bore.

11. Procédé selon la revendication 10, **caractérisé en ce que** la couche semi-conductrice dopée (10) est formée par diffusion à haute température de BBr₃ ou de BCl₃ par la face arrière du substrat (1).

12. Procédé selon l'une des revendications 9 à 11, **caractérisé en ce que** la couche dopante (11) est une couche de nitrure de silicium dopée au phosphore.

13. Procédé selon l'une des revendications 1 à 12, **caractérisé en ce que** l'épaisseur de la couche semi-conductrice dopée (10) est comprise entre 100 nm et 1 µm et **en ce que** l'épaisseur de la couche dopante (11) est comprise entre 10 et 300 nm.

14. Procédé selon l'une des revendications 1 à 13, **caractérisé en ce qu'**avant la formation de la couche dopante (11), on forme sur la couche semi-conductrice dopée (10) une couche d'oxyde de silicium.

15. Procédé selon l'une des revendications 1 à 14, **caractérisé en ce que** les irradiations sélectives sont effectuées au moyen d'un laser.

16. Procédé selon l'une des revendications 1 à 15, **caractérisé en ce qu'**il comprend la formation, sur la face avant (F) dudit substrat (1), d'une couche semi-conductrice (2) dopée du même type électrique que le substrat (1), de sorte à former un champ électrique répulsif sur ladite face avant (F).

17. Procédé selon la revendication 16, **caractérisé en ce que** ladite couche (2) de champ électrique répulsif est formée par diffusion à haute température de POCl₃ dans le substrat (1).

18. Structure comprenant un substrat (1) de silicium dopé, recouvert successivement d'une couche semi-conductrice dopée (10) avec une première espèce de dopants et d'une couche dite dopante (11) comprenant une seconde espèce de dopants, de type électrique opposé à celui de la première espèce (10), **caractérisée en ce que** la couche semi-conductrice dopée (10) comprend au moins une région (10a) dopée de type opposé à celui de la première espèce, comprenant des dopants de la seconde espèce en concentration supérieure à celle des dopants de la première espèce, et une région (10b) électriquement isolante, comprenant des dopants de la seconde espèce, en concentration équilibrée avec celle des dopants de la première espèce, ladite région (10b) électriquement isolante étant agencée de sorte à séparer une région (10c) de la couche (10) dopée avec la première espèce d'au moins une région (10a) dopée de type opposé à celui de la première espèce.

19. Cellule photovoltaïque à contacts interdigités en face arrière, comprenant un substrat (1) de silicium dopé, et, sur la face arrière (B) dudit substrat, une alternance, sous la forme d'un peigne interdigité, de régions dopées p+ et de régions dopées n+, ladite cellule étant **caractérisée en ce que** l'ensemble desdites régions p+ et n+ présente une concentration sensiblement homogène en dopants d'une même espèce et **en ce que** ladite cellule comprend en outre, sur la face arrière (B) du substrat (1), une pluralité de régions électriquement isolantes séparant les régions dopées p+ et les régions dopées n+, lesdites régions électriquement isolantes présentant une concentration en dopants de ladite espèce sensiblement homogène à celle des régions dopées p+ et des régions dopées n+.

## Patentansprüche

1. Verfahren zur Herstellung einer Photovoltaikzelle mit ineinandergreifenden Kontakten auf der Rückseite, **dadurch gekennzeichnet, dass** es umfasst:
- das Bereitstellen eines dotieren Siliziumsubstrats (1),
- das Bilden, auf der Rückseite (B) des Substrats (1), einer mit einer ersten Dotierungsmittel-Spezies dotierten halbleitenden Schicht (10),
- das Bilden, auf der dotierten halbleitenden Schicht (10), einer dotierenden Schicht (11), die eine zweite Spezies von Dotierungsmitteln elektrischen Typs entgegengesetzt zur ersten Spezies (10) umfasst,
- das Bilden, in der dotierten halbleitenden Schicht (10), mindestens einer dotierten Region (10a) entgegengesetzten Typs zur ersten Spezies durch selektive Bestrahlung mindestens einer Region (11a) der dotierenden Schicht (11) durch einen Lichtstrom, dessen Fluenz größer als ein Grenzwert (S₂), bezeichnet als "Dotierungs-Inversionsgrenzwert", ist, jenseits dessen die Dotierungsmitteln der bestrahlten Region (11a) der dotierenden Schicht (11) in die darunterliegende Region (10a) der dotierten halbleitenden Schicht (10) derart diffundieren, dass die Konzentration der ersten Dotierungsmittel-Spezies überschritten wird,
- das Bilden, in der dotierten halbleitenden Schicht (10), mindestens einer elektrisch isolierenden Region (10b) durch selektive Bestrahlung mindestens einer Region (11b) der dotierenden Schicht (11) durch einen Lichtstrom, dessen Fluenz in einem Bereich ([S₁ - S₂]), bezeichnet als "Dotierungs-Kompensationsbereich", unter dem Dotierungs-Inversionsgrenzwert (S₂) liegt, für den die Dotierungsmitteln der bestrahlten Region (11b) der dotierenden Schicht (11) in die darunterliegende Region (10b) der dotierten halbleitenden Schicht (10) derart diffundieren, dass die Konzentrationen der zwei Dotierungsmittel-Spezies in der Region (10b) ausgeglichen werden, wobei die elektrisch isolierende Region (10b) derart ausgebildet ist, dass eine Region (10c) der mit der ersten Spezies dotierten Schicht (10) von mindestens einer dotierten Region (10a) entgegengesetzten Typs zur ersten Spezies getrennt ist.

2. Verfahren nach Anspruch 1, **dadurch gekennzeichnet, dass** die selektive Bestrahlung von der Rückseite (B) des Substrats (1) durchgeführt wird.

3. Verfahren nach einem der Ansprüche 1 bis 2, **dadurch gekennzeichnet, dass** die dotierte Schicht (10) durch Hochtemperatur-Diffusion eines Reagens gebildet wird, das die erste Dotierungsmittel-Spezies von der Rückseite (B) des Substrats (1) enthält.

4. Verfahren nach einem der Ansprüche 1 bis 3, **dadurch gekennzeichnet, dass** die dotierende Schicht (11) eine mit der zweiten Dotierungsmittel-Spezies dotierte Siliziumnitridschicht ist, die durch chemische Abscheidung in der Dampfphase, unterstützt durch Plasma (PECVD), aufgebracht ist.

5. Verfahren nach einem der Ansprüche 1 bis 4, **dadurch gekennzeichnet, dass** die erste Dotierungsmittel-Spezies vom selben elektrischen Typ wie das Substrat (1) ist.

6. Verfahren nach Anspruch 5, **dadurch gekennzeichnet, dass** das Substrat (1) n-dotiert ist und dass die erste Dotierungsmittel-Spezies Phosphor ist.

7. Verfahren nach Anspruch 6, **dadurch gekennzeichnet, dass** die dotierte halbleitende Schicht (10) durch Hochtemperatur-Diffusion von POCl₃ von der Rückseite des Substrats (1) gebildet wird.

8. Verfahren nach einem der Ansprüche 5 bis 7, **dadurch gekennzeichnet, dass** die dotierende Schicht (11) eine mit Bor dotierte Siliziumnitridschicht ist.

9. Verfahren nach einem der Ansprüche 1 bis 4, **dadurch gekennzeichnet, dass** die erste Dotierungsmittel-Spezies vom entgegengesetzten elektrischen Typ wie das Substrat (1) ist.

10. Verfahren nach Anspruch 9, **dadurch gekennzeichnet, dass** das Substrat (1) n-dotiert ist und dass die erste Dotierungsmittel-Spezies Bor ist.

11. Verfahren nach Anspruch 10, **dadurch gekennzeichnet, dass** die dotierte halbleitende Schicht (10) durch Hochtemperatur-Diffusion von BBr₃ oder von BCl₃ von der Rückseite des Substrats (1) gebildet wird.

12. Verfahren nach einem der Ansprüche 9 bis 11, **dadurch gekennzeichnet, dass** die dotierende Schicht (11) eine mit Phosphor dotierte Siliziumnitridschicht ist.

13. Verfahren nach einem der Ansprüche 1 bis 12, **dadurch gekennzeichnet, dass** die Dicke der dotierten halbleitenden Schicht (10) zwischen 100 nm und 1 µm inklusive ist und dass die Dicke der dotierenden Schicht (11) zwischen 10 und 300 nm inklusive ist.

14. Verfahren nach einem der Ansprüche 1 bis 13, **dadurch gekennzeichnet, dass** auf der dotierten halbleitenden Schicht (10) vor der Bildung der dotierenden Schicht (11) eine Siliziumoxidschicht gebildet wird.

15. Verfahren nach einem der Ansprüche 1 bis 14, **dadurch gekennzeichnet, dass** die selektiven Bestrahlungen mittels eines Lasers durchgeführt werden.

16. Verfahren nach einem der Ansprüche 1 bis 15, **dadurch gekennzeichnet, dass** es auf der Vorderseite (F) des Substrats (1) die Bildung einer dotierten halbleitenden Schicht (2) desselben elektrischen Typs wie das Substrat (1) umfasst, so das auf der Vorderseite (F) ein repulsives elektrisches Feld gebildet wird.

17. Verfahren nach Anspruch 16, **dadurch gekennzeichnet, dass** die Schicht (2) mit repulsivem elektrischem Feld durch Hochtemperatur-Diffusion von POCl₃ im Substrat (1) gebildet wird.

18. Struktur, die ein dotiertes Siliziumsubstrat (1) umfasst, das schrittweise von einer mit einer ersten Dotierungsmittel-Spezies dotierten halbleitenden Schicht (10) und einer dotierenden Schicht (11), die eine zweite Dotierungsmittel-Spezies entgegengesetzten Typs zur ersten Spezies (10) umfasst, bedeckt wird, **dadurch gekennzeichnet, dass** die dotierte halbleitende Schicht (10) mindestens eine dotierte Region (10a) entgegengesetzten Typs zur ersten Spezies umfasst, umfassend Dotierungsmittel der zweiten Spezies in höherer Konzentration als die ersten Dotierungsmittel der ersten Spezies, und eine elektrisch isolierende Region (10b), umfassend Dotierungsmittel der zweiten Spezies in ausgewogener Konzentration mit den Dotierungsmitteln der ersten Spezies, wobei die elektrisch isolierende Region (10b) derart ausgebildet ist, dass eine Region (10c) der mit der ersten Spezies dotierten Schicht (10) von mindestens einer dotierten Region (10a) entgegengesetzten Typs zur ersten Spezies getrennt ist.

19. Photovoltaikzelle mit ineinandergreifenden Kontakten auf der Rückseite, umfassend ein dotiertes Siliziumsubstrat (1), und, auf der Rückseite (B) des Substrats, eine Abfolge in Form eines ineinandergreifenden Kamms, von p+-dotierten Regionen und n+-dotierten Regionen, wobei die Zelle **dadurch gekennzeichnet ist, dass** die Gesamtheit der p+- und n+-Regionen eine etwa homogene Dotierungsmittelkonzentration einer selben Spezies aufweist und dass die Zelle ferner auf der Rückseite (B) des Substrats (1) eine Vielzahl elektrisch isolierender Regionen umfasst, die die p+-dotierten Regionen und die n+-dotierten Regionen trennen, wobei die elektrisch isolierenden Regionen eine Dotierungsmittelkonzentration der Spezies aufweist, die etwa der der p+-dotierten Regionen und der n+-dotierten Regionen entspricht.

## Claims

1. A method for producing a photovoltaic cell with interdigitated back contacts, **characterized in that** it comprises:
- providing a doped silicon substrate (1);
- forming on the back surface (B) of said substrate (1), a semiconductor layer (10) doped with a first species of dopants;
- forming, on said doped semiconductor layer (10), a so-called doping layer (11) comprising a second species of dopants of opposite electric type to the first species (10);
- forming in the doped semiconductor layer (10), at least one doped region (10a) of opposite type to the first species via selective irradiation of at least one region (11a) of the doping layer (11) using a luminous flux whose fluence is higher than a threshold (S₂), called "doping inversion threshold", beyond which the dopants of the irradiated region (11a) of the doping layer (11) diffuse into the region (10a) underlying the doped semiconductor layer (10) so as to exceed the concentration of the first dopant species;
- forming in the doped semiconductor layer (10) at least one electrically insulating region (10b) via selective irradiation of at least one region (11b) of the doping layer (11) using luminous flux having fluence within a range ([S₁-S₂]) called "doping compensation range", that is lower than said doping inversion threshold (S₂) and at which the dopants of the irradiated region (11b) of the doping layer (11) diffuse into the region (10b) underlying the doped semiconductor layer (10) to obtain equilibrium concentration of the two species of dopants in said region (10b), said electrically insulating region (10b) being arranged so as to separate a region (10c) of layer (10) doped with the first species from at least one region (10a) having doping of opposite type to the first species.

2. The method according to claim 1, **characterized in that** said selective irradiation is performed via the back surface (B) of the substrate (1).

3. The method according to one of claims 1 to 2, **characterized in that** the doped layer (10) is formed by high temperature diffusion of a reagent containing the first dopant species via the back surface (B) of the substrate (1).

4. The method according to one of claims 1 to 3, **characterized in that** the doping layer (11) is a layer of silicon nitride doped with the second dopant species deposited by plasma enhanced chemical vapour deposition (PECVD).

5. The method according to one of claims 1 to 4, **characterized in that** the first dopant species is of same electric type as the substrate (1).

6. The method according to claim 5, **characterized in that** the substrate (1) is n doped and **in that** the first dopant species is phosphorus.

7. The method according to claim 6, **characterized in that** the doped semiconductor layer (10) is formed by high temperature diffusion of POCl₃ via the back surface of the substrate (1).

8. The method according to one of claims 5 to 7, **characterized in that** the doping layer (11) is a layer of boron-doped silicon nitride.

9. The method according to one of claims 1 to 4, **characterized in that** the first dopant species is of opposite electric type to the substrate (1).

10. The method according to claim 9, **characterized in that** the substrate (1) is n doped and **in that** the first dopant species is boron.

11. The method according to claim 10, **characterized in that** the doped semiconductor layer (10) is formed by high temperature diffusion of BBr₃ or BCl₃ via the back surface of the substrate (1).

12. The method according to one of claims 9 to 11, **characterized in that** the doping layer (11) is a layer of phosphorus-doped silicon nitride.

13. The method according to one of claims 1 to 12, **characterized in that** the thickness of the doped semiconductor layer (10) is between 100 nm and 1 µm, and **in that** the thickness of the doping layer (11) is between 10 and 300 nm.

14. The method according to one of claims 1 to 13, **characterized in that** before forming the doping layer (11), a layer of silicon oxide is formed on the doped semiconductor layer (10).

15. The method according to one of claims 1 to 14, **characterized in that** the selective irradiations are performed by laser.

16. The method according to one of claims 1 to 15, **characterized in that** it comprises the forming, on the front surface (F) of said substrate (1), of a doped semiconductor layer (2) of same electric type as the substrate (1), so as to form a repulsive electric field on said front surface (F).

17. The method according to claim 16, **characterized in that** said layer (2) of repulsive electric field is formed by high temperature diffusion of POCl₃ in the substrate (1).

18. A structure comprising a doped silicon substrate (1) successively coated with a semiconductor layer (10) doped with a first dopant species and a so-called doping layer (11) comprising a second dopant species of opposite electric type to the first species (10), **characterized in that** the doped semiconductor layer (10) comprises at least one doped region (10a) of opposite type to the first species, comprising dopants of the second species in a concentration higher than the concentration of the first dopant species, and an electrically insulating region (10b) comprising dopants of the second species in equilibrium concentration with the concentration of dopants of the first species, said electrically insulating region (10b) being arranged so as to separate a region (10c) of layer (10) doped with the first species from at least one region (10a) having doping of opposite-type to the first species.

19. A photovoltaic cell with interdigitated back contacts comprising a doped silicon substrate (1) and, on the back surface (B) of said substrate, alternating p+ doped regions and n+ doped regions in the form of an interdigitated comb, said cell being **characterized in that** all said p+ and n+ regions have a substantially homogeneous concentration of dopants of one same species, and **in that** said cell further comprises, on the back surface (B) of the substrate (1), a plurality of electrically insulating regions separating the p+ doped regions and n+ doped regions, said electrically insulating regions having a concentration of dopants of said species that is substantially homogeneous with that of the p+ regions and n+ doped regions.
